# EUROPEAN PATENT APPLICATION

(11) **EP 4 321 659 A1**
(43) Date of publication of application: **14.02.2024**
(21) Application number: 22784653.2
(22) Date of filing: 01.04.2022
(51) Int. Cl.: C30B 29/38, C23C 14/06, C30B 25/06, H01L 21/20, H01L 21/203, H01L 33/32

(54) **MULTILAYER FILM STRUCTURE AND PRODUCTION METHOD THEREFOR**

(30) Priority: 05.04.2021 JP 2021063918
(71) Applicant: Tosoh Corporation, Yamaguchi 746-8501 (JP)
(72) Inventor: UEOKA, Yoshihiro, Ayase-shi, Kanagawa 252-1123 (JP); SUEMOTO, Yuya, Ayase-shi, Kanagawa 252-1123 (JP); MESUDA, Masami, Ayase-shi, Kanagawa 252-1123 (JP)
(74) Representative: Novagraaf International SA
(86) International application number: PCT/JP2022/017010
(87) International publication number: WO 2022/215670

(57) **Abstract**

An object is to provide at least one of a multilayer film structure having high crystallinity and high flatness and a method for producing the multilayer film structure and is further to provide at least one of a multilayer film structure that includes a SiC substrate and a nitride-based film formed on the substrate by a sputtering process and that can be applied to power devices and a method for producing the multilayer film structure. A multilayer film structure includes a SiC substrate and a film disposed on the SiC substrate and containing a nitride-based material at least containing Ga, wherein the multilayer film structure has an off-angle of 0.03° or more and 8° or less with respect to a Silicon face of a (0001) plane of a SiC single crystal forming the SiC substrate and the film containing the nitride-based material has a C content of 2 × 10¹⁹ atoms/cm³ or less and a Cl content of 2 × 10¹⁸ atoms/cm³ or less.

## Description

### TECHNICAL FIELD

The present invention relates to a multilayer film structure and a method for producing the multilayer film structure.

### BACKGROUND ART

Nitride-based materials exhibit excellent semiconductor characteristics. For example, gallium nitride (GaN) is put into practical use as a material for blue light-emitting diodes (LEDs) or blue laser diodes (LD). In addition, gallium nitride has high withstand voltage performance and hence is suitable for applications such as power devices. Thus, multilayer film structures in which a film of a nitride-based material (hereafter, also referred to as "nitride-based film") is disposed on a substrate are useful in the field of electronic devices.

Patent Documents 1 to 4 disclose techniques relating to production of nitride-based films and represented by the metal organic chemical vapor deposition (MOCVD) process.

Patent Document 1 discloses a method for producing a nitride-based film by the MOCVD process and discloses a method of simultaneously injecting a reaction gas and a pressing diffusion gas to thereby grow a semiconductor crystal film (nitride-based film). Patent Document 1 specifically states that, in Examples, ammonia, hydrogen gas and TMG (trimethylgallium) gas are used to form a gallium nitride film on a sapphire substrate.

Patent Document 2 discloses that the hydride vapor phase epitaxy (HVPE) process is used to grow a gallium nitride film on a GaAs (111) single crystal substrate.

Patent Document 3 discloses a film formation method for forming a gallium nitride film on a sapphire substrate by sputtering using, as a sputtering target, a metallic-gallium-permeated gallium nitride molded body in which gallium nitride and metallic gallium are present as different phases in the molded body and the molar ratio Ga/(Ga + N) of the whole molded body is 55% or more and 80% or less.

Patent Document 4 discloses a silicon carbide (SiC) substrate for growing a gallium nitride compound semiconductor layer in which the SiC substrate has an epitaxial growth surface in which the off-angle of the C face (0001) of the SiC single crystal with respect to the Silicon face is set in the range of 0.03° to 0.3°. Patent Document 4 states that, in Examples, a nitride-based film is grown on a SiC substrate by the MOCVD process.

### PRIOR ART DOCUMENTS

### PATENT DOCUMENTS

Patent Document 1: JP-A-H04-164895
Patent Document 2: JP-A-2000-12900
Patent Document 3: JP-A-2014-159368
Patent Document 4: JP-A-2020-75839

### DISCLOSURE OF INVENTION

### TECHNICAL PROBLEM

The MOCVD process in Patent Documents 1 and 4 and the HVPE process in Patent Document 2 are all chemical film formation processes. The MOCVD process or the HVPE process respectively involves a reaction requiring an organometallic material or a chloride material. Thus, in each process, impurities such as carbon or chlorine tend to be incorporated into the deposited nitride-based film. As a result, the resultant nitride-based film has a high impurity concentration and devices formed from such films have noticeably degraded characteristics. By contrast, the sputtering process disclosed in Patent Document 3 is a physical film formation process and raw material particles from the sputtering target are caused, by physical impact, to adhere to the substrate. Thus, the process does not require the organometallic material or the chloride material and reduction in the carbon and chloride impurity concentrations can be achieved. In addition, the equipment for rendering the organometallic material or the chloride material harmless is not required and growth of nitride-based films can be achieved under reduced loads on the environment.

However, in the case of applications such as power devices, existing nitride-based films formed on SiC substrates by the sputtering process do not have sufficient crystallinity.

In addition, the influence of the off-angle of SiC substrates on the crystallinity of nitride-based films formed by the sputtering process is not known.

The present invention has been accomplished on the basis of such findings; an object is to provide at least one of a multilayer film structure having high crystallinity and high flatness and a method for producing the multilayer film structure and another object is to provide at least one of a multilayer film structure that includes a SiC substrate and a nitride-based film formed on the substrate by a sputtering process and that can be applied to power devices and a method for producing the multilayer film structure.

### SOLUTION TO PROBLEM

The inventors of the present invention have found that influences due to the off-angle of SiC substrates are considerably different between a nitride-based film formed by the MOCVD process and a nitride-based film formed by the sputtering process and have found that the off-angle of a SiC substrate is controlled, so that the sputtering process can provide, on the SiC substrate, a highly crystalline nitride-based film.

Specifically, the present invention is described in Claims and encompasses embodiments (1) to (15) below. Note that, in this Description, expressions of "a value 'to' a value" include both of these values. Specifically, "X to Y" has the same meaning as "X or more and Y or less". "X and/or Y" has the same meaning as "at least one of X and Y (one or both of X and Y, specifically "X, Y, or X and Y")".
(1) A multilayer film structure comprising a SiC substrate and a film disposed on the SiC substrate and containing a nitride-based material at least containing Ga, wherein the multilayer film structure has an off-angle of 0.03° or more and 8° or less with respect to a Silicon face of a (0001) plane of a SiC single crystal forming the SiC substrate and the film containing the nitride-based material has a C content of 2 × 10¹⁹ atoms/cm³ or less and a Cl content of 2 × 10¹⁸ atoms/cm³ or less.
(2) The multilayer film structure according to (1) above, wherein a (0002) plane in a surface has a rocking-curve full width at half maximum of 5.30° or less.
(3) The multilayer film structure according to (1) above, wherein the nitride-based material is gallium nitride.
(4) The multilayer film structure according to any one of (1) to (3) above, wherein the multilayer film structure has a surface having an arithmetic average roughness (Ra) of 10.0 nm or less.
(5) The method according to any one of (1) to (4) above, wherein the film containing the nitride-based material has a film thickness of 20 nm or more.
(6) The multilayer film structure according to any one of (1) to (5) above, wherein the multilayer film structure has a surface formed of a hexagonal gallium nitride layer and the gallium nitride layer has a surface having gallium (Ga) polarity.
(7) The multilayer film structure according to any one of (1) to (6) above, wherein an amorphous is present on the SiC substrate and the amorphous layer has a thickness of 0 nm or more and less than 1.0 nm.
(8) The multilayer film structure according to (7) above, wherein the amorphous layer has a thickness of more than 0 nm and less than 1.0 nm.
(9) The multilayer film structure according to any one of (1) to (8) above, wherein the film containing the nitride-based material is a gallium nitride-based sputtered film.
(10) A semiconductor device comprising the multilayer film structure according to any one of (1) to (9) above.
(11) An electronic device comprising the semiconductor device according to (10) above.
(12) A method for producing the multilayer film structure according to any one of (1) to (9) above, the method comprising a step of preparing a SiC substrate, a step of immersing the SiC substrate in a cleaning solution and a step of forming, on the immersed SiC substrate, a film containing a nitride-based material by a sputtering process, wherein, during formation of the film containing the nitride-based material, a sputtering energy (Es) represented by Formula: Es = [supplied power (unit: W/cm²)]/[introduced gas pressure (unit: Pa)]² is set to 0.1 W/cm²Pa² or more and 150 W/cm²Pa² or less.
(13) The production method according to (12) above, wherein the sputtering process is performed after an ultimate vacuum of less than 5.0 × 10⁻⁴ Pa is reached.
(14) The production method according to (12) or (13) above, wherein, during formation of the film containing the nitride-based material, an ultimate vacuum within a film-forming apparatus immediately before film formation is set to 1 × 10⁻⁴ Pa or less.
(15) The production method according to any one of (12) to (14) above, wherein the sputtering process is performed using a target having a carbon content of 1 mass% or less and a chlorine content of 100 ppm or less.

### ADVANTAGEOUS EFFECTS OF INVENTION

The present invention provides at least one of a multilayer film structure having high crystallinity and high flatness and a method for producing the multilayer film structure. Another object is to provide at least one of a multilayer film structure that includes a SiC substrate and a nitride-based film formed on the substrate by a sputtering process and that can be applied to power devices and a method for producing the multilayer film structure.

### BRIEF DESCRIPTION OF DRAWINGS

[Fig. 1] A schematic view illustrating an example of a section of a multilayer film structure.
[Fig. 2] A schematic view illustrating another example of the section of the multilayer film structure.
[Fig. 3] A schematic view illustrating an example of a semiconductor device.
[Fig. 4] A schematic view illustrating another example of the semiconductor device.

### DESCRIPTION OF EMBODIMENTS

Specific embodiments according to the present invention (hereafter, also referred to as "embodiments") will be described. Note that the present invention is not limited to the following embodiments and the embodiments can be modified in various ways without departing from the spirit and scope of the present invention.

### [Multilayer film structure]

An embodiment provides a multilayer film structure comprising a SiC substrate and a film disposed on the SiC substrate and containing a nitride-based material at least containing Ga, wherein the multilayer film structure has an off-angle of 0.03° or more and 8° or less with respect to a Silicon face of a (0001) plane of a SiC single crystal forming the SiC substrate and the film containing the nitride-based material has a C content of 2 × 10¹⁹ atoms/cm³ or less and a Cl content of 2 × 10¹⁸ atoms/cm³ or less. Silicon carbide (SiC) has a lattice constant close to lattice constants of nitride-based films, which facilitates epitaxial growth of nitride-based films. Furthermore, SiC has high thermal conductivity and high heat radiation performance and hence the multilayer film structure according to the embodiment in which the support substrate for the nitride-based film is formed of silicon carbide is expected to exhibit characteristics suitable for applications in which a large amount of heat is generated, such as power devices.

The multilayer film structure according to the embodiment includes a SiC substrate serving as, what is called, a support substrate. The SiC substrate constituting the multilayer film structure according to the embodiment is a substrate formed of silicon carbide (SiC) and, in particular, a substrate formed of a silicon carbide single crystal (SiC single crystal substrate).

In the SiC substrate, the off-angle with respect to the Silicon face of the (0001) plane of the SiC single crystal forming the SiC substrate (hereafter, also simply referred to as "off-angle") is 0.03 degrees or more and 8 degrees or less (0.03° or more and 8° or less). When the off-angle is excessively small, the terrace length (terrace width) of the atomic steps of the SiC single crystal increases. Thus, a film containing a nitride-based material having a high crystallinity equivalent to the high crystallinity of the SiC substrate inferentially becomes less likely to grow. On the other hand, when the off-angle is excessively large, the terrace length of the atomic steps decreases. Thus, a film containing a highly crystalline nitride-based material becomes likely to be provided; however, the yield of the SiC substrates obtained from SiC single crystal ingots decreases. This results in, for example, an increase in the production costs of SiC substrates, which is inferentially problematic in terms of the costs.

In the embodiment, the off-angle is 0.03° or more and 8° or less, preferably 0.05° or more and 6° or less, 0.06° or more and 5° or less, 0.08° or more and 4° or less, 0.1° or more and 4° or less, or 0.1° or more and 2° or less. In another embodiment, the off-angle is 0.03° or more, 0.08° or more, or 1° or more and 8° or less, or 5° or less.

The (0001) planes of a SiC single crystal (in other words, equivalent planes corresponding to the C axis of the SiC crystal) include the Silicon face (what is called, the (0001) face) and the Carbon face (what is called, the (000-1) face) opposite to the Silicon face. The Silicon face is a face used for growing a gallium-containing nitride film that functions as a gallium nitride-based compound semiconductor, in other words, a face for growing the film containing the nitride-based material in the multilayer film structure according to the embodiment.

The off-angle is an angle with respect to the reference crystal plane direction. The direction of the off-angle is not limited. The off-angle is, for example, a tilt angle with respect to the (0001) plane direction toward the (1-100) direction or the (11-20) direction, preferably a tilt angle with respect to the (0001) plane direction toward the (11-20) direction. As the SiC substrate constituting the multilayer film structure according to the embodiment, at least one of a SiC substrate in which the tilt angle with respect to the (0001) plane direction toward the (1-100) direction satisfies the above-described off-angle value and a substrate in which the tilt angle with respect to the (0001) plane direction toward the (11-20) direction satisfies the above-described off-angle value can be used; a SiC substrate in which the tilt angle with respect to the (0001) plane direction toward the (11-20) direction satisfies the above-described off-angle value is preferably used. More specifically, the SiC substrate constituting the multilayer film structure according to the embodiment may have an off-angle with respect to the (0001) plane direction toward the (11-20) direction, the off-angle being 0.03° or more and 8° or less, 0.05° or more and 8° or less, or 3° or more and 6° or less.

The off-angle can be determined by, for example, X-ray diffractometry using 2θ/ω scanning and ω scanning. In the measurement of the off-angle, X-ray diffraction measurement can be performed using an ordinary X-ray diffractometer (for example, D8 DISCOVER, manufactured by Bruker AXS GmbH) under the following conditions.

Accelerating current ·voltage: 50 mA 50 kV
Radiation source: CuKα radiation (λ = 1.5405 Å)
Measurement mode: continuous scanning
Scanning condition: 2°/min
Measurement range: 2θ = 10° to 90°
Divergence height limiting slit: 10 mm
Divergence/incident slit: 1°
Receiving slit: open
Receiving Soller slits: 5°
Detector: semiconductor detector (D/teX Ultra)
Filter: Ni filter

The XRD pattern can be measured using an ordinary powder X-ray diffractometer (for example, Ultima IV, manufactured by Rigaku Corporation). The crystalline XRD peak is a peak detected by determining 2θ of the peak top in the analysis of the XRD pattern using an ordinary analysis software (for example, SmartLab Studio II, manufactured by Rigaku Corporation). The analysis conditions for the XRD pattern may be the following conditions.

Fitting conditions: automatic, background refinement
   Variance-type pseudo-Voigt function (peak profile)
Background subtraction method: fitting method
Kα2 removal method: Kα1/Kα2 ratio = 0.497
Smoothing method: B-Spline curve
Smoothing conditions: second-derivative method, σ cut value = 3,
   χ threshold = 1.5

The SiC substrate constituting the multilayer film structure according to the embodiment is a SiC substrate having the above-described off-angle and the method for producing the SiC substrate is not limited. The SiC substrate may be a SiC substrate produced by the sublimation method or the melt method or a SiC epi-substrate (SiC epitaxial substrate) in which a SiC single crystal layer is epitaxially grown on a SiC single crystal substrate produced by such a method.

The SiC substrate constituting the multilayer film structure according to the embodiment may be one or more selected from the group consisting of semiconductive, n-type and p-type and is preferably at least one of semiconductive and n-type, more preferably n-type.

The SiC substrate may contain a dopant element such as a donor or an acceptor in the surface and/or the inside. However, the SiC substrate does not necessarily contain dopant elements. The dopant element contained in the SiC substrate may be, for example, one or more selected from the group consisting of boron, nitrogen, aluminum and phosphorus.

In general, the SiC substrate as obtained has a surface covered with a natural oxide film or a natural nitride film. These natural oxide film and the like are amorphous and have a thickness of about 1 to about 3 nm. When a SiC substrate in which a natural oxide film (amorphous layer) remains is used, the film of the nitride-based material may have degraded crystallinity. By contrast, when a SiC substrate from which the natural oxide film is almost completely removed is used, the gallium-containing nitride film can have improved crystallinity. Thus, the SiC substrate constituting the multilayer film structure according to the embodiment is preferably a SiC substrate not having a natural oxide film (in other words, not having an amorphous phase or having an amorphous layer having a thickness of 0 nm). However, the multilayer film structure according to the embodiment may include a SiC substrate that has a natural oxide film (amorphous phase) without impairing advantages of the multilayer film structure and the SiC substrate may include an amorphous phase having a thickness of less than 1 nm or less than 0.5 nm.

The multilayer film structure according to the embodiment includes a film containing a nitride-based material at least containing Ga (hereafter, also referred to as "gallium-containing nitride film"). The gallium-containing nitride film contains the nitride-based material at least containing Ga (hereafter, also referred to as "gallium-containing nitride material") and the gallium-containing nitride film may be formed of the gallium-containing nitride material.

The gallium-containing nitride film is preferably a film formed by sputtering, what is called, a sputtered film.

The gallium-containing nitride film is preferably one or more selected from the group consisting of a gallium nitride film, an aluminum gallium nitride film, an indium gallium nitride film and an aluminum indium gallium nitride film. Furthermore, from the viewpoint of being useful as a material for light-emitting elements such as blue light-emitting diodes (LEDs) or blue laser diodes (LDs) or semiconductor devices such as power devices, the gallium-containing nitride film is more preferably a gallium nitride film. When the gallium-containing nitride film is formed of gallium nitride (GaN), the multilayer film structure according to the embodiment can itself be applied to electronic devices such as light-emitting elements or semiconductor devices. Furthermore, the multilayer film structure according to the embodiment can be used as a base substrate and gallium nitride can be further formed on the multilayer film structure. The gallium nitride formed on the multilayer film structure according to the embodiment can be epitaxially grown and hence the multilayer film structure according to the embodiment including the gallium nitride can be used to provide a device having good characteristics.

In the embodiment, the gallium-containing nitride material is not limited in terms of type as long as it is a nitride-based material containing gallium (Ga). For example, the gallium-containing nitride material is a material that functions as a group III-V semiconductor, contains at least gallium (Ga) as a group III element and contains nitrogen (N) as a group V element.

Specifically, the gallium-containing nitride material may be, for example, one or more selected from the group consisting of gallium nitride, aluminum gallium nitride and indium gallium nitride and is preferably gallium nitride (GaN).

The gallium-containing nitride material is not limited to materials having stoichiometric compositions. For example, gallium nitride has a stoichiometric composition in which the ratio of gallium (Ga) to nitrogen (N) (atomic ratio) is 1:1. When the gallium-containing nitride material contained in the gallium-containing nitride film is gallium nitride, deviation from the stoichiometric composition is allowed as long as the crystalline structure of gallium nitride is maintained and the gallium nitride may be gallium nitride not having the stoichiometric composition. For example, in the embodiment, when the gallium-containing nitride material is gallium nitride, the gallium nitride may have a composition in which the atomic ratio of Ga:N is 0.9:1.0 to 1.1:1.0.

The gallium-containing nitride material may contain a dopant element. The dopant element may be one or more elements selected from the group consisting of Ar, O, Si, Fe, Mg and Mn. On the other hand, the gallium-containing nitride material does not necessarily contain a dopant element.

When the dopant element is contained, the dopant element content is preferably 1 × 10¹⁷ atoms/cm³ or more (1 × 10¹⁷ atoms/cm³ or more), more preferably 1 × 10¹⁸ atoms/cm³ or more, still more preferably 1 × 10¹⁹ atoms/cm³ or more. In the embodiment, the dopant element is contained as long as advantages of the embodiment are provided; for example, the dopant element content may be 1 × 10²² atoms/cm³ or less or 1 × 10²¹ atoms/cm³ or less. Note that, in the embodiment, for convenience, carbon (C) and chlorine (Cl) are not regarded as the dopant elements.

In the multilayer film structure according to the embodiment, in the gallium-containing nitride film, the C content is 2 × 10¹⁹ atoms/cm³ or less (2 × 10¹⁹ atoms/cm³ or less) and the Cl content is 2 × 10¹⁸ atoms/cm³ or less (2 × 10¹⁸ atoms/cm³ or less).

The gallium-containing nitride film included in the multilayer film structure according to the embodiment has high crystallinity and the gallium-containing nitride film in contact with the SiC substrate has a low C (carbon) content and a low Cl (chlorine) content. Specifically, the C content is 2.0 × 10¹⁹ atoms/cm³ or less and the Cl content is 2.0 × 10¹⁸ atoms/cm³ or less. The C and Cl contents are low, so that the gallium-containing nitride film has high crystallinity. In addition, the gallium-containing nitride film has a low impurity content (specifically, the C and Cl contents), so that another film can be epitaxially grown thereon. This enables production of devices having good characteristics such as semiconductor devices.

The C content is preferably 8.0 × 10¹⁸ atoms/cm³ or less, more preferably 4.0 × 10¹⁸ atoms/cm³ or less, still more preferably 2.0 × 10¹⁸ atoms/cm³ or less, yet more preferably 1.0 × 10¹⁸ atoms/cm³ or less, particularly preferably 8.0 × 10¹⁷ atoms/cm³ or less. The C content is preferably low and may be 0 atoms/cm³ or more, more than 0 atoms/cm³, or 5.0 × 10¹⁷ atoms/cm³ or more.

The Cl content is preferably 8.0 × 10¹⁷ atoms/cm³ or less, more preferably 4.0 × 10¹⁷ atoms/cm³ or less, still more preferably 2.0 × 10¹⁷ atoms/cm³ or less, yet more preferably 1.0 × 10¹⁷ atoms/cm³ or less, particularly preferably 8.0 × 10¹⁶ atoms/cm³ or less. The Cl content is preferably low and may be 0 atoms/cm³ or more, more than 0 atoms/cm³, or 5.0 × 10¹⁶ atoms/cm³ or more.

The lower limit of the impurity content in the gallium-containing nitride film is not limited. The C and Cl contents may each be 1.0 × 10¹⁴ atoms/cm³ or more, 1.0 × 10¹⁵ atoms/cm³ or more, or 1.0 × 10¹⁶ atoms/cm³ or more.

In the embodiment, the C and Cl contents can each be determined by secondary ion mass spectroscopy (SIMS) and can be determined by, for example, secondary ion mass spectroscopy using a secondary ion mass spectrometer (PCOR-SIMS; point by point correction-SIMS, EAG Laboratories).

The gallium-containing nitride film included in the multilayer film structure according to the embodiment preferably has high crystallinity. The phrase "high crystallinity" means a state in which crystals within the film are highly oriented and preferably means that the gallium-containing nitride film satisfies FWHM described later. When the gallium-containing nitride film has high crystallinity, the multilayer film structure according to the embodiment can be suitably used as a base layer during production of a light-emitting element such as an LED or an element for a power device on a SiC substrate. Alternatively, the multilayer film structure according to the embodiment can be suitably used as a template substrate for growing a highly crystalline gallium nitride film.

As long as the gallium-containing nitride film serving as a constituent element of the embodiment can be regarded as a film or a thin film, its thickness is not limited. The gallium-containing nitride film preferably has a film thickness of 20 nm or more, more preferably 30 nm or more, still more preferably 40 nm or more. The upper limit of the film thickness is not limited and may be 1000 nm or less, 500 nm or less, 250 nm or less, or 150 nm or less.

The film thickness can be determined by, using a transmission electron microscope, observing a section of the multilayer film structure. Alternatively, a plurality of films may be prepared by sputtering under the same conditions; the film thicknesses may be determined using a contact-type film thickness gauge or an optical film thickness gauge; and the film deposition rate determined from the film thicknesses may be used to calculate the film thickness. The method of measuring the film thickness is preferably the measurement method using a contact-type film thickness gauge.

The multilayer film structure according to the embodiment includes a SiC substrate having a face having an off-angle of 0.03 degrees or more and 8 degrees or less (0.03° or more and 8° or less) and at least one gallium-containing nitride film disposed on the SiC substrate.

In the embodiment, "multilayer film structure" is a structure including at least a substrate and one or more films stacked on the substrate.

The multilayer film structure according to the embodiment includes a SiC substrate and a gallium-containing nitride film disposed on the SiC substrate. The SiC substrate has a gallium-containing nitride film thereon and the gallium-containing nitride film is disposed on the SiC substrate. The gallium-containing nitride film may be disposed directly on the SiC substrate or may be disposed on the SiC substrate with another layer therebetween.

In the multilayer film structure according to the embodiment, when the gallium-containing nitride film is disposed on the SiC substrate with another layer therebetween, the other layer may be an amorphous layer and may be at least one of a natural oxide film and a natural nitride film. In the multilayer film structure according to the embodiment, an amorphous layer may be present on the SiC substrate and the SiC substrate and the gallium-containing nitride may be stacked with the amorphous layer therebetween. Specifically, the multilayer film structure according to the embodiment may include the amorphous layer on the SiC substrate, may be a multilayer film structure in which the SiC substrate, the amorphous layer, and the Ga-containing material film layer are stacked or may be a multilayer film structure having a configuration in which the SiC substrate, the amorphous layer and the Ga-containing material film layer are sequentially stacked.

The amorphous layer has a thickness of less than 1.0 nm, preferably 0 nm or more and less than 1.0 nm, more preferably 0 nm or more and 0.5 nm or less.

The amorphous layer is, for example, a layer formed of a reaction product of the surface of the SiC substrate and nitrogen, may be an amorphous oxide layer, may be a layer containing at least one amorphous substance of silicon dioxide and silicon nitride or may be a layer formed of at least one of amorphous silicon dioxide and amorphous silicon nitride.

In the multilayer film structure according to the embodiment, the surface preferably has an arithmetic average roughness (Ra) of 10.0 nm or less, more preferably 5.0 nm or less, still more preferably 2.0 nm or less, particularly preferably 1.0 nm or less. When the substrate has such an arithmetic average surface roughness (Ra), the substrate is suitable for forming a device on the surface and the substrate surface has sufficient smoothness for forming the device. The arithmetic average surface roughness (Ra) is ideally 0 nm. However, in actuality, the multilayer film structure has surface roughness and hence the multilayer film structure according to the embodiment has an arithmetic average surface roughness (Ra) of more than 0 nm, for example, 0.5 nm or more, or 0.7 nm or more.

Similarly, the gallium-containing nitride film constituting the multilayer film structure according to the embodiment preferably has such an arithmetic average roughness (Ra).

The surface roughness can be measured using a scanning probe microscope (for example, NanoScope IIIa, manufactured by Bruker AXS GmbH).

In the multilayer film structure according to the embodiment, the (0002) plane in the surface preferably has a rocking-curve full width at half maximum (FWHM: hereafter, also simply referred to as "FWHM") of 5.30° or less, 5.00 degrees (°) or less, 3.00 degrees (°) or less, 2.00° or less, or 1.50 degrees (°) or less. The smaller the FWHM, the higher the crystallinity; the FWHM may be, for example, 0° or more, 0.1° or 1.00° or more. When the multilayer film structure according to the embodiment is a multilayer film structure constituted by a SiC substrate and a gallium-containing nitride film, in the multilayer film structure according to the embodiment, the rocking-curve full width at half maximum of the (0002) plane in the surface may be the rocking-curve full width at half maximum (FWHM) of the (0002) plane of the gallium-containing nitride film.

In the embodiment, FWHM is a value evaluated by X-ray diffractometry and the evaluation conditions may be the following conditions.

- Radiation source: CuKα radiation (λ = 0.15418 nm)
- Monochromator: Ge (220)
- Pathfinder: Crystal3B
- Measurement mode: ω scanning
- Measurement intervals: 0.01°
   (0.002° in the case of a full width at half maximum of 0.1° or less)
- Measurement time: 0.5 seconds
- Measurement range: ω = 0° to 35°

In the multilayer film structure according to the embodiment, the surface, for example, the surface of the gallium-containing nitride film is preferably formed of a hexagonal gallium nitride layer and the gallium nitride layer preferably has a surface having gallium (Ga) polarity. When the surface has gallium (Ga) polarity, during further formation of gallium nitride (GaN) on the multilayer film structure, hexagonal facets that hamper production of devices become less likely to be formed.

Hereinafter, as the multilayer film structure according to the embodiment, a multilayer film structure not including an amorphous layer (first embodiment) and a multilayer film structure including an amorphous layer (second embodiment) will be individually described.

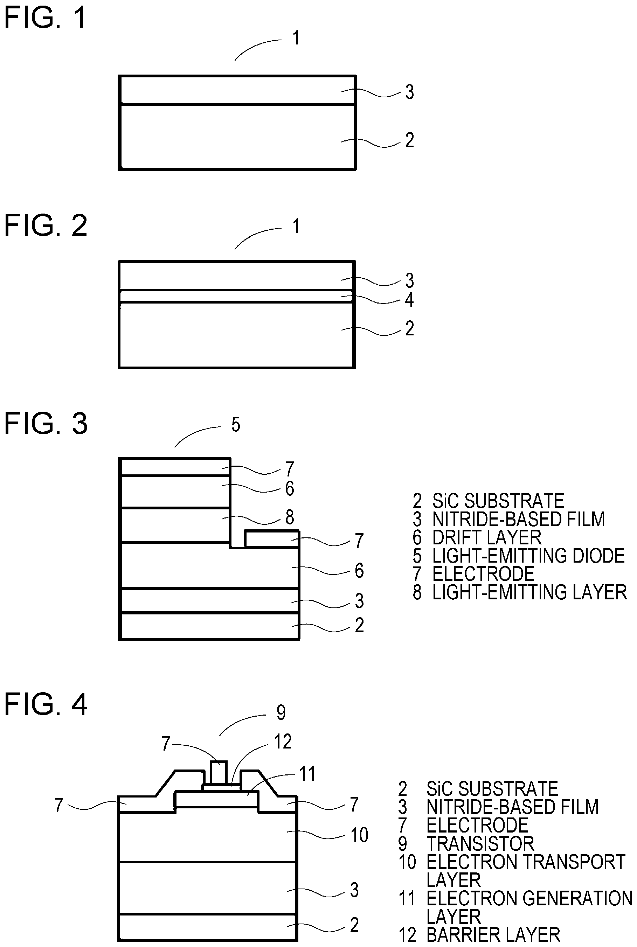

Fig. 1 is a schematic sectional view of the multilayer film structure according to the first embodiment. In Fig. 1, a multilayer film structure (1) includes a SiC substrate (2) and a film formed of a nitride-based material (gallium-containing nitride film) (3) disposed on the SiC substrate (2). In the first embodiment, an amorphous layer is not present. Specifically, the amorphous layer has a thickness of 0 nm and the gallium-containing nitride film (3) is directly in contact with the SiC substrate (2) without any other layer therebetween.

When the gallium-containing nitride film (3) is directly in contact with the SiC substrate (2), in other words, the gallium-containing nitride film is disposed directly on the SiC substrate (2), the crystallinity of the gallium-containing nitride film (3) and further the crystallinity of the surface of the multilayer film structure are improved. Specifically, when the gallium-containing nitride film (3) is directly in contact with the highly crystalline SiC substrate (2), the crystal of the gallium-containing nitride film (3) is grown while having crystallinity similar to the crystallinity of the SiC substrate (2). In other words based on the production method, the gallium-containing nitride film (3) is epitaxially grown well.

In the first embodiment, as long as the high crystallinity is inherited on the gallium-containing nitride film (3), another layer may be present. Specifically, a structure may be provided in which, in the multilayer film structure according to the first embodiment, the gallium-containing nitride film (3) is used as a buffer layer and a highly crystalline layer is disposed on the gallium-containing nitride film (SiC substrate/gallium-containing nitride film/highly crystalline layer). The highly crystalline layer may be a gallium-containing nitride film; the composition of this layer may be the same as or different from that of the gallium-containing nitride film serving as the buffer layer.

In the first embodiment, an amorphous layer is not included and hence the contrast of the amorphous layer is not clearly observed between the SiC substrate and the gallium-containing nitride film in an observation image captured by cross-sectional TEM, for example.

Fig. 2 is a schematic sectional view of the multilayer film structure according to the second embodiment. This multilayer film structure (1) includes a SiC substrate (2) and a film formed of a nitride-based material at least containing Ga (gallium-containing nitride film) (3) disposed on the SiC substrate (2). In the second embodiment, an amorphous layer (4) is present between the SiC substrate (2) and the gallium-containing nitride film (3). The amorphous layer (4) has a thickness of more than 0 nm and less than 1.0 nm and further 0.1 nm or more and 0.5 nm or less. When the amorphous layer (4) has a thickness of less than 1.0 nm, even when the amorphous layer (4) is present, the gallium-containing nitride film (3) has high crystallinity. By contrast, when an amorphous layer having a thickness of 1.0 nm or more is present on the SiC substrate (2), epitaxial growth of the gallium-containing nitride film (3) is hampered and the gallium-containing nitride film (3) has degraded crystallinity. Furthermore, when the amorphous layer (4) has a thickness of 1.0 nm or more, the crystals of the gallium-containing nitride film (3) are not oriented and a polycrystalline film is provided.

The amorphous layer is not particularly limited in terms of material, is typically an amorphous oxide layer, is formed of silicon dioxide and/or silicon nitride and more typically formed of silicon dioxide.

In the second embodiment, as long as the high crystallinity of the gallium-containing nitride film (3) is maintained, another layer other than the amorphous layer (4) may be present between the SiC substrate (2) and the gallium-containing nitride film (3). However, the other layer other than the amorphous layer (4) is preferably not present. Another layer may be present on the gallium-containing nitride film (3) as long as the high crystallinity is inherited.

In each of the first embodiment and the second embodiment, the combination in the gallium-containing nitride material forming the gallium-containing nitride film is not limited as long as it contains Ga; the film is more preferably a gallium nitride-based film, particularly preferably a gallium nitride film. The gallium-containing nitride film may be formed of one or two or more gallium-containing nitride materials. In other words, the gallium-containing nitride film may contain two or more gallium-containing nitride materials. Furthermore, the gallium-containing nitride film may include a plurality of layers.

Furthermore, the film of the nitride-based material is disposed on the Silicon face of the SiC substrate, so that the surface of the gallium nitride (GaN) forming the film of the nitride-based material is easily made to have gallium (Ga) polarity inferentially.

The gallium-containing nitride film is preferably a gallium nitride-based sputtered film.

A preferred form of the embodiment may be a multilayer film structure having a configuration in which, on a SiC substrate, a film containing a nitride-based material at least containing Ga is disposed,
wherein the SiC substrate is formed of a SiC single crystal and has an off-angle of 0.03° or more and 8° or less with respect to a SiC (0001) plane, and
the nitride-based material contained in the film has a carbon content of 2 × 10¹⁹ atoms/cm³ or less and a chlorine content of 2 × 10¹⁸ atoms/cm³ or less.

A more preferred form of the embodiment may be a multilayer film structure having a configuration in which, on a single-crystal SiC substrate, a gallium nitride film is disposed,
wherein an off-angle is 0.03° or more and 8° or less with respect to a (0001) plane of SiC forming the single-crystal SiC substrate, and
the gallium nitride film has a carbon content of 2 × 10¹⁹ atoms/cm³ or less and a chlorine content of 2 × 10¹⁸ atoms/cm³ or less.

A preferred form of the embodiment may be a multilayer film structure including a SiC substrate and a nitride film containing gallium,
wherein the nitride film is disposed on the SiC substrate directly or with an amorphous layer therebetween,
the SiC substrate is formed of a SiC single crystal,
an off-angle with respect to a SiC (0001) plane of the SiC substrate is 0.03° or more and 8° or less,
the nitride film has a carbon content of 2 × 10¹⁹ atoms/cm³ or less and a chlorine content of 2 × 10¹⁸ atoms/cm³ or less, and
a (0002) plane of the nitride film has a rocking-curve full width at half maximum of 5.00° or less.

### [Semiconductor device and electronic device]

A semiconductor device according to an embodiment comprises the multilayer film structure according to the embodiment.

An electronic device according to an embodiment comprises the semiconductor device according to the embodiment. Examples of the semiconductor device include light-emitting elements such as blue light-emitting diodes (LEDs) and blue laser diodes (LDs) (Fig. 3) and power devices such as diodes and transistors (Fig. 4). The semiconductor device may include the multilayer film structure according to the embodiment serving as a base layer and a film and/or a thick film disposed on the base layer and formed of a nitride-based material such as gallium nitride (GaN). The semiconductor device and the electronic device may include, in addition to the multilayer film structure, another functional component. The high crystallinity of the nitride-based film constituting the multilayer film structure results in good characteristics of the semiconductor device and the electronic device.

### [Method for producing multilayer film structure]

The multilayer film structure according to the embodiment is not limited in terms of production method as long as it satisfies the above-described features and can be preferably produced by the following production method.

Specifically, the method for producing the multilayer film structure according to the embodiment comprises a step of preparing a SiC substrate (hereafter, also referred to as "substrate preparation step"), a step of immersing the SiC substrate in a cleaning solution (hereafter, also referred to as "wet etching step") and a step of forming, on the immersed SiC substrate, a film containing a nitride-based material by a sputtering process (hereafter, also referred to as "film formation step"), wherein, during formation of the film containing the nitride-based material, a sputtering energy (Es) represented by Formula: Es = [supplied power (unit: W/cm²)]/[introduced gas pressure (unit: Pa)]² is set to 0.1 W/cm²Pa² or more and 150 W/cm²Pa² or less.

Preferably, the method for producing the multilayer film structure according to the embodiment includes a step of preparing a SiC substrate, a step of immersing the SiC substrate in a cleaning solution for 3 seconds or more and a step of forming a film containing a nitride-based material on the immersed SiC substrate, after an ultimate vacuum of less than 5.0 × 10⁻⁴ Pa is reached, by a sputtering process using a sputtering target having a carbon content of less than 1 mass% and a chlorine content of less than 100 ppm, wherein, during formation of the film containing the nitride-based material, the sputtering energy (Es) represented by Formula: Es = [supplied power (unit: W/cm²)]/[introduced gas pressure (unit: Pa)]² is set to 0.1 W/cm²Pa² or more and 150 W/cm²Pa² or less.

Hereinafter, the steps will be described in detail.

### <Substrate preparation step>

In the substrate preparation step, a SiC substrate is prepared. The SiC substrate is not limited in terms of production method, may be a SiC substrate produced by the sublimation method or the melt growth method or may be a SiC epi-substrate in which, on a SiC single-crystal substrate produced by such a method, a SiC single-crystal layer is epitaxially grown. The SiC substrate may or may not contain, in the surface and/or the inside, a dopant element such as a donor or an acceptor.

### <Wet etching step>

In the wet etching step, the prepared SiC substrate is immersed in a cleaning solution. The SiC substrate subjected to the wet etching step is the SiC substrate having the above-described off-angle and is preferably a SiC substrate formed of a SiC single crystal having the above-described off-angle.

The shape of the SiC substrate is not limited and is similar to that of the desired multilayer film structure. The shape of the SiC substrate may be, for example, a disc shape, a disc shape having a diameter of 10 mm or more and 150 mm or less or a disc shape having a diameter of 25 mm or more and 120 mm or less.

The thickness of the SiC substrate is sufficiently large relative to the thickness of the gallium-containing nitride film and may be, for example, 200 µm or more, or 300 µm or more, or 1000 µm or less, or 600 µm or less.

The resistivity of the SiC substrate is not limited and may be, for example, 1.0 × 10⁻³ Ω·cm or more, or 1.0 × 10⁻² Ω·cm or more, or 1.0 × 10⁸ Ω·cm or less, 1.0 × 10⁷ Ω·cm or less, or 1.0 × 10⁻¹ Ω·cm or less.

In the wet etching step, a treatment of removing (treatment of cleaning off) contamination substances or an oxide film in the surface of the SiC substrate is performed.

The cleaning solution may be one or more selected from the group consisting of an aqueous solution of hydrofluoric acid, sulfuric acid, hydrochloric acid, hydrogen peroxide, ammonium hydroxide, trichloroethylene, acetone, methanol, and isopropanol and is preferably an aqueous solution of hydrofluoric acid. In the immersion, an ultrasonic cleaning machine may also be used to perform an ultrasonic treatment and the SiC substrate may be immersed in the cleaning solution.

In the case of using, as the cleaning solution, an aqueous solution of hydrofluoric acid, the hydrofluoric acid concentration of the aqueous solution of hydrofluoric acid is preferably 1 to 10 mass% (1 mass% or more and 10 mass% or less), more preferably 5 to 10 mass% (5 mass% or more and 10 mass% or less). When the hydrofluoric acid concentration is set to 5 mass% or more, modification of the surface using hydrogen can be efficiently achieved. When the hydrofluoric acid concentration is set to 10 mass% or less, the surface roughness of the SiC substrate having been subjected to the wet etching treatment becomes less likely to increase.

The immersion time of the SiC substrate is preferably 3 seconds or more and 100 seconds or less, more preferably 5 seconds or more and 100 seconds or less (5 to 100 seconds). When the immersion time is set to 5 seconds or more, the oxide film is sufficiently removed and, in the produced multilayer film structure, the thickness of the amorphous layer can be decreased. When the immersion time is set to 100 seconds or less, the surface roughness during etching can be suppressed.

The immersion time may be 20 seconds or more and 100 seconds or less, or may be 20 seconds or more and 50 seconds or less. This facilitates production of the multilayer film structure according to the first embodiment in which the amorphous layer has a thickness of 0 nm (an amorphous substance is not present). The immersion time may be 5 seconds or more and less than 20 seconds. This enables production of the multilayer film structure according to the second embodiment in which the amorphous layer has a thickness of more than 0 nm and less than 1.0 nm.

After the immersion in the cleaning solution, residual droplets on the surface of the substrate are removed. The residual droplets can be removed by a process such as surface blowing using nitrogen gas.

In the SiC substrate having been subjected to the wet etching treatment, the oxide film is preferably sufficiently removed and the surface is preferably planarized. The SiC substrate having been subjected to the wet etching treatment has an arithmetic average roughness (Ra) of 0.5 nm or less, preferably 0.3 nm or less. The SiC substrate preferably has a low arithmetic average roughness, which may be, for example, 0 nm or more, or 0.1 nm or more.

After the removal of the residual droplets, impurities in the atmosphere tend to contaminate the surface of the substrate; thus, before a lapse of 24 hours or more, the film formation step of forming a nitride-based material film is preferably performed; specifically, the transition time from the wet etching step to the film formation step is preferably less than 24 hours, more preferably 12 hours or less, or 5 hours or less. The shorter the transition time, the more preferable it is; the transition time may be, for example, 15 minutes or more, or 30 minutes or more.

In actuality, the SiC substrate has a natural oxide film; however, in the case of supplying, as the SiC substrate, a SiC substrate not having a natural oxide film, the production method of this example does not necessarily include the wet etching step.

### <Film formation step>

In the film formation step, on the SiC substrate having been subjected to the wet etching treatment, a sputtering process is performed to form a film of a nitride-based material, specifically, a film of a nitride-based material at least containing Ga (gallium-containing nitride film). As a result, a gallium-containing nitride sputtered film is formed to provide the multilayer film structure according to the embodiment.

The sputtering process is a publicly known process and may be, for example, one or more selected from the group consisting of the DC sputtering process, the RF sputtering process, the AC sputtering process, the DC magnetron sputtering process, the RF magnetron sputtering process, the pulse sputtering process, and the ion-beam sputtering process. From the viewpoint of enabling large-area, uniform, high-speed film formation, the sputtering process is preferably a magnetron sputtering process, more preferably at least one of the DC magnetron sputtering process and the RF magnetron sputtering process.

As the sputtering target (hereafter, also simply referred to as "target"), publicly known targets used for film formation of nitride-based films can be used. Such a target may be at least one of a metallic target and a nitride-based target.

From the viewpoint of improving the crystallinity of the whole film, the lower the C content and the Cl content of the target, the more preferable it is. The sputtering process is preferably performed using, for example, a target having, on the basis of analysis by glow discharge mass spectrometry (GDMS), a carbon content of 1 mass% or less, 1000 mass ppm or less, or 100 mass ppm or less and a chlorine content of 100 ppm or less, or 10 ppm or less.

The C content and the Cl content are each preferably 100 ppm (weight ratio) or less, 50 ppm or less, or 10 ppm or less. The C content and the Cl content are preferably low; however, as long as the target provides the desired gallium-containing nitride film, the lower limits of the contents are not limited. For example, the target may have a carbon content of 0 ppm or more, more than 0 ppm, or 10 ppm or more and the target may have a chlorine content of 0 ppm or more, more than 0 ppm, or 0.5 ppm or more.

As the area of the target increases, film formation on a substrate having a larger area can be achieved and the uniformity of the film thickness and the film quality is improved. Thus, the area of the target is preferably 18 cm² or more, more preferably 100 cm² or more. Note that the area of the target is the area of one of the main surfaces of the target.

The sputtering process is preferably performed after an ultimate vacuum of less than 5.0 × 10⁻⁴ Pa, or 1.0 × 10⁻⁵ Pa or less is reached.

During the formation of the nitride-based film, the ultimate vacuum within the film-forming apparatus immediately before the film formation is preferably 1 × 10⁻⁴ Pa or less, 7 × 10⁻⁵ Pa or less, 2 × 10⁻⁵ Pa or less, 9 × 10⁻⁶ Pa or less, or 5 × 10⁻⁶ Pa or less. When the degree of vacuum within the apparatus before the film formation is high, ingress of residual gas impurities into the deposition film (nitride-based film) during the film formation is likely to be suppressed. This results in a further improvement in the crystallinity of the deposited film. The higher the ultimate vacuum, the more preferable it is; the ultimate vacuum may be, for example, 1 × 10⁻⁶ Pa or more, or 2 × 10⁻⁶ Pa or more.

For the purpose of removing the residual gas, the apparatus before the film formation may be subjected to a baking treatment.

The sputtering film formation is preferably performed while the substrate is heated. This promotes migration of particles deposited on the substrate, to form a deposited film having a stable crystalline state. The substrate heating temperature (also referred to as "film formation temperature" or "substrate temperature") is preferably 100°C to 800°C, more preferably 200°C to 600°C. Furthermore, the sputtering is preferably performed with a substrate temperature set to 400°C or more and 850°C or less.

As the gas introduced during the sputtering, publicly known gases used for film formation of nitride-based films can be used. Such a gas may be at least one of argon (Ar) and nitrogen (N₂) and is preferably a gas containing at least argon, more preferably a mixture gas of argon and nitrogen. As needed, another gas such as ammonia may be introduced.

During film formation of the nitride-based film, the sputtering energy (Es) is set to 0.1 W/cm²Pa² or more and 150 W/cm²Pa² or less. The sputtering energy (Es) is the energy of the sputtered particles during sputtering film formation and is defined by Formula: Es = [supplied power density (unit: W/cm²)]/[introduced gas pressure (unit: Pa)]².

The supplied power density (Es) is the supplied energy per unit area determined by dividing the supplied power by the area of the target. In such a case, a highly crystalline film can be formed. The specific reason for this is not clarified; however, the magnitude of the sputtering energy (Es) causes changes in characteristics of the sputtered particles such as the adhesiveness of the sputtered particles having reached the substrate, the diffusion length of migration of the sputtered particles on the substrate and/or the entry depth into the deposited film, which inferentially affect the crystallinity of the nitride-based film. Es is 0.1 W/cm²Pa² or more, preferably 0.5 W/cm²Pa² or more, 1 W/cm²Pa² or more, 2 W/cm²Pa² or more, or 10cm²Pa² or more. Es is 100 W/cm²Pa² or less, 60 W/cm²Pa² or less, or 30 W/cm²Pa² or less.

As needed, a step of further forming another nitride-based film on the nitride-based film may be performed. For example, as the nitride-based film, a gallium nitride-based film is formed by a sputtering process and subsequently a gallium nitride-based film may further be formed thereon by an MOCVD process.

In this way, the multilayer film structure according to the embodiment is produced.

### EXAMPLES

The present invention will be further described with reference to the following Examples and Comparative Examples. However, the present invention is not limited to the following Examples.

### (1) Evaluation

The multilayer film structure obtained in each of Examples and Comparative Examples was evaluated in the following manner.

### <Structural analysis>

The region between the SiC substrate and the nitride-based film was analyzed to determine the presence or absence of an amorphous layer and its thickness. As a pretreatment, a carbon coating was formed on the surface of the multilayer film structure and subsequently focused ion beam (FIB) processing was performed to prepare an observation sample. Subsequently, a field-emission transmission electron microscope (manufactured by JEOL Ltd., JEM-2100F) was used to observe a section of the observation sample. At this time, the electron-beam accelerating voltage was set to 200 kV.

### <Elements contained in multilayer film structure>

A secondary ion mass spectrometer (Eurofins EAG, PCOR-SIMS) was used to evaluate the C and Cl contents of the nitride-based film. The nitride-based film was analyzed while being ground from the surface; in the profiles to the SiC substrate, the lowest concentrations were extracted.

### <Surface roughness of multilayer film structure>

The arithmetic average roughness (Ra) of the surface of the multilayer film structure was measured. The measurement was performed using a scanning probe microscope (Bruker AXS, NanoScope IIIa) by tapping-mode AFM in a field of view of 2 µm × 2 µm.

### <Polarity of multilayer film structure>

A time-of-flight atom scattering spectroscopy (PASCAL CO., LTD., TOFLAS-3000) was used to evaluate the polarity and the crystal phase of the gallium nitride film. The multilayer film structure was set in the apparatus with the film surface facing upside and measured. The pole figure obtained by the measurement was compared with pole figures obtained by simulation for the crystal phases and polarities of four layers from the surface, to thereby evaluate the polarity and the crystal phase of the gallium nitride film. Note that details of the measurement conditions were as follows.

- Probe: He (atom scattering)
- Energy: 3 keV
- Beam source-target distance: 805 mm
- Target-detector distance: 395 mm
- Degree of vacuum in analysis chamber: 2 × 10⁻³ Pa or less

### <Crystallinity of multilayer film structure>

An X-ray diffractometer (manufactured by Bruker AXS GmbH, D8 DISCOVER) was used to evaluate the crystallinity of the surface of the multilayer film structure. The analysis was performed under conditions of 40 kV and 40 mA in the HIGH RESOLUTION mode. In order to remove CuKα2, a monochromator was used and ω scanning was performed. The rocking curve of the (0002) plane was measured and the full width at half maximum (FWHM) was determined, which was used as the index of the crystallinity of the film. Note that details of the analysis conditions were as follows.

- Radiation source: CuKα radiation (λ = 0.15418 nm)
- Monochromator: Ge (220)
- Pathfinder: Crystal3B
- Measurement mode: ω scanning
- Measurement intervals: 0.01°
   (0.002° in the case of a full width at half maximum of 0.1° or less)
- Measurement time: 0.5 seconds
- Measurement range: ω = 0° to 35°

### [Example 1] (Example)

### <Preparation step>

As the SiC substrate, an n-type SiC substrate (off by 4° with respect to the Silicon face toward the (11-20) direction, in other words, an off-angle of 4°) was prepared. The substrate had a diameter of 50 ± 0.5 mm (50 mm), a thickness of 330 ± 25 µm (330 µm) and a resistivity of 0.015 Ω·cm or more (0.015 Ω·cm).

### <Wet etching step>

The SiC substrate was subjected to a wet etching treatment (cleaning treatment). First, hydrofluoric acid (KANTO CHEMICAL CO., INC., Ultrapure grade) was diluted with ultrapure water (KANTO CHEMICAL CO., INC., Ultrapure grade) to provide a diluted aqueous solution of hydrofluoric acid having a hydrogen fluoride concentration of 5 mass%. The SiC substrate was immersed in the diluted aqueous solution of hydrofluoric acid for 30 seconds and subsequently taken out of the diluted aqueous solution of hydrofluoric acid. Subsequently, nitrogen gas was blown to remove droplets remaining on the surface of the SiC substrate.

This provided the SiC substrate having been subjected to the cleaning treatment (Ra: 0.15 nm). Subsequently, without delay (within 1 hour), the obtained SiC substrate was subjected to a film formation step (the film formation step of a nitride-based film described below).

### <Film formation step of nitride-based film>

A magnetron sputtering apparatus was used to perform an RF magnetron sputtering process to form a nitride-based film on the SiC substrate having been subjected to the wet etching treatment. Specifically, as the sputtering target, a gallium nitride (GaN) target (purity: 99.99 mass%, carbon content: 20 ppm, chlorine content: 1 ppm) was used. The SiC substrate and the target were placed within the film formation chamber of the sputtering apparatus and the film formation chamber was evacuated. After the degree of vacuum within the film formation chamber (ultimate vacuum before film formation) reached 1.8 × 10⁻⁶ Pa, sputtering was started to start formation of the gallium nitride film.

The film formation was performed using, as the introduction gas into the film formation chamber, a mixture gas of nitrogen (flow rate: 20 sccm) and argon (flow rate: 3 sccm) under conditions of a substrate temperature of 800°C and a sputtering energy of 10 W/cm²Pa². In this way, a gallium nitride (GaN) film having a film thickness of 50 nm was formed to produce a multilayer film structure in which the gallium nitride film was disposed on the SiC substrate (multilayer film structure including the SiC substrate and the gallium nitride film and having a structure in which the gallium nitride film is disposed on the SiC substrate).

### [Example 2 to Example 5] (Examples)

Multilayer film structures were produced as in Example 1 except that the conditions of the film formation step of the nitride-based film were changed to the conditions in Table 1.

### [Example 6] (Example)

A multilayer film structure was produced as in Example 1 except that the immersion time for the SiC substrate in the diluted aqueous solution of hydrofluoric acid in the wet etching treatment was changed to 5 seconds and the conditions of the film formation step of the nitride-based film were changed to the conditions in Table 1.

### [Example 7 (Comparative Example)]

A multilayer film structure was produced as in Example 1 except that the immersion time for the SiC substrate in the diluted aqueous solution of hydrofluoric acid in the wet etching treatment was changed to 2 seconds and the conditions of the film formation step of the nitride-based film were changed to the conditions in Table 1.

### [Example 8 (Comparative Example)]

A multilayer film structure was produced as in Example 1 except that a GaN target having a C content of 100 ppm or more (1 mass%) was used and the conditions of the film formation step of the nitride-based film were changed to the conditions in Table 1.

### [Example 9 (Comparative Example)]

A multilayer film structure was produced as in Example 1 except that a GaN target having a Cl content of 100 ppm or more (100 mass ppm) was used and the conditions of the film formation step of the nitride-based film were changed to the conditions in Table 1.

### [Examples 10 to 12 (Comparative Examples)]

Multilayer film structures were produced as in Example 1 except that the conditions of the film formation step of the nitride-based film were changed to the conditions in Table 1.

### [Example 13 (Comparative Example)]

A GaN film was grown on a SiC substrate by the metal organic vapor deposition process (MOCVD process) to produce a multilayer film structure.

### [Example 14 (Comparative Example)]

A GaN film was grown on a SiC substrate by the hydride vapor phase epitaxy (HVPE process) to produce a multilayer film structure.

### [Examples 15 and 16] (Examples)

Multilayer film structures were produced as in Example 1 except that, as the SiC substrate, a semiconductive SiC substrate (off by 0.1° with respect to the Silicon face toward the (11-20) direction, in other words, an off-angle of 0.1°) was prepared and the conditions in Table 1 were employed. The substrate had a diameter of 101.6 ± 0.5 mm, a thickness of 500 ± 25 µm and a resistivity of 1.0 × 10⁷ Ω·cm.

### [Examples 17 and 18] (Examples)

Multilayer film structures were produced as in Example 1 except that, as the SiC substrate, an n-type SiC substrate (off by 4° with respect to the Silicon face toward the (11-20) direction, in other words, an off-angle of 4°) was prepared and the conditions in Table 1 were employed. The substrate had a diameter of 101.6 ± 0.5 mm, a thickness of 350 ± 25 µm and a resistivity of 0.01 Ω·cm.

### [Examples 19 and 20] (Examples)

Multilayer film structures were produced as in Example 1 except that, as the SiC substrate, an n-type SiC substrate (off by 8° with respect to the Silicon face toward the (11-20) direction, in other words, an off-angle of 8°) was prepared and the conditions in Table 1 were employed. The substrate had a diameter of 101.6 ± 0.5 mm, a thickness of 350 ± 25 µm and a resistivity of 0.01 Ω·cm.

### (3) Results

For Example 1 to Example 20, the evaluation results will be described in Table 2. Note that Example 1 to Example 6 and Examples 15 to 20 are Examples while Example 7 to Example 14 are Comparative Examples.

In particular, in Example 1 to Example 5, the C content was a low content of 1.9 × 10¹⁹ atoms/cm³ or less and the Cl content was a low content of 4.9 × 10¹⁷ atoms/cm³ or less. In addition, the amorphous layer had a small thickness of 0.2 nm or less. Furthermore, the arithmetic average roughness (Ra) was a small value of 1.8 nm or less and the full width at half maximum (FWHM) was a small value of 3.8° or less. As a result, in Example 1 to Example 6, production of hexagonal-phase Ga-polarity gallium nitride films (nitride-based films) having low impurity content, high flatness and high crystallinity was achieved.

By contrast, in Comparative Examples (Example 7 to Example 14), the C or Cl content was high and the crystallinity and the surface flatness were poor. For example, in Example 7 in which the immersion time of the Si substrate was 2 seconds, an amorphous layer was present and its thickness was 1.2 nm. In Example 8 and Example 9 in which the targets had a C content or Cl content of 100 ppm or more, the resultant multilayer film structures had, in the surfaces, a high C content or a high Cl content. In Example 10 in which the ultimate vacuum was 5.0 × 10⁻⁴ Pa, the FWHM was large and the crystallinity was low. In Example 11 in which the sputtering energy (Es) was set to 0.05 W/cm²Pa² and Example 12 in which the sputtering energy (Es) was set to 200 W/cm²Pa², the multilayer film structures had, in the surfaces, a large FWHM and low crystallinity. In Example 13 in which the GaN film was grown by the MOCVD process, the C content was high; in Example 14 in which the GaN film was grown by the HVPE process, the Cl content was high.

**[Table 1]**

| | Ultimate vacuum before film formation [×10⁻⁶Pa] | Target | Sputtering energy Es | Introduction gas [sccm] | | Substrate temperature [°C] | Film thickness [nm] |
|---|---|---|---|---|---|---|---|
| | | | | Nitrogen | Argon | | |
| Example 1 | 1.8 | GaN | 10 | 20 | 3 | 800 | 100 |
| Example 2 | 3.0 | GaN | 20 | 20 | 3 | 800 | 100 |
| Example 3 | 2.3 | GaN | 30 | 20 | 3 | 800 | 100 |
| Example 4 | 2.4 | GaN | 20 | 20 | 0 | 800 | 100 |
| Example 5 | 3.0 | GaN | 20 | 20 | 3 | 500 | 100 |
| Example 6 | 3.6 | GaN | 20 | 20 | 3 | 500 | 100 |
| Example 7* | 2.5 | GaN | 20 | 20 | 3 | 800 | 100 |
| Example 8* | 2.3 | GaN | 20 | 20 | 3 | 800 | 100 |
| Example 9* | 2.0 | GaN | 20 | 20 | 3 | 800 | 100 |
| Example 10* | 500.0 | GaN | 10 | 20 | 3 | 800 | 100 |
| Example 11* | 20.0 | GaN | 0.05 | 20 | 3 | 800 | 100 |
| Example 12* | 9.0 | GaN | 200 | 20 | 3 | 800 | 100 |
| Example 15 | 2.5 | GaN | 0.1 | 20 | 3 | 800 | 50 |
| Example 16 | 3.3 | GaN | 80 | 20 | 3 | 800 | 100 |
| Example 17 | 3.5 | GaN | 0.1 | 20 | 3 | 800 | 50 |
| Example 18 | 3.1 | GaN | 80 | 20 | 3 | 800 | 100 |
| Example 19 | 2.5 | GaN | 0.1 | 20 | 3 | 800 | 50 |
| Example 20 | 2.6 | GaN | 80 | 20 | 3 | 800 | 100 |

| | | | | | | | |
|---|---|---|---|---|---|---|---|
| "*" mean Comparative Examples. | | | | | | | |

**[Table 2]**

| | Amorphous layer thickness [nm] | C content [×10¹⁹ atoms/cm³] | Cl content [×10¹⁸ atoms/cm³] | Arithmetic average roughness Ra [nm] | Crystallinity, polarity | FWHM [°C] |
|---|---|---|---|---|---|---|
| Example 1 | 0 | 1.90 | 0.078 | 1.8 | Hexagonal phase, Ga polarity | 2.9 |
| Example 2 | 0 | 0.78 | 0.10 | 1.2 | Hexagonal phase, Ga polarity | 3.2 |
| Example 3 | 0 | 0.30 | 0.25 | 1.1 | Hexagonal phase, Ga polarity | 2.8 |
| Example 4 | 0 | 0.078 | 0.49 | 0.6 | Hexagonal phase, Ga polarity | 1.1 |
| Example 5 | 0 | 0.52 | 0.097 | 1.1 | Hexagonal phase, Ga polarity | 1.8 |
| Example 6 | 0.2 | 0.66 | 0.092 | 1.3 | Hexagonal phase, Ga polarity | 3.8 |
| Example 7* | 1.2 | 0.78 | 0.78 | 2.3 | Cubic phase | 5.5 |
| Example 8* | 0 | 18.00 | 0.75 | 2.1 | Cubic phase | 4.8 |
| Example 9* | 0 | 0.62 | 73.00 | 2.4 | Cubic phase | 4.4 |
| Example 10* | 0 | 1.80 | 0.78 | 1 | Hexagonal phase, Ga polarity | 5.6 |
| Example 11* | 0 | 0.84 | 0.35 | 1 | Cubic phase | 6.2 |
| Example 12* | 0 | 0.98 | 0.51 | 1 | Hexagonal phase, Ga polarity | 7.1 |
| Example 13* | 0 | 2.80 | 0.032 | 0.6 | Hexagonal phase, Ga polarity | 0.05 |
| Example 14* | 0 | 0.001 | 2.40 | 0.5 | Hexagonal phase, Ga polarity | 0.1 |
| Example 15 | 0 | 0.240 | 0.490 | 1.1 | Hexagonal phase, Ga polarity | 4.1 |
| Example 16 | 0 | 0.330 | 0.490 | 1.3 | Hexagonal phase, Ga polarity | 0.12 |
| Example 17 | 0 | 0.50 | 0.490 | 1.2 | Hexagonal phase, Ga polarity | 4.6 |
| Example 18 | 0 | 0.30 | 0.490 | 0.9 | Hexagonal phase, Ga polarity | 3.0 |
| Example 19 | 0 | 0.80 | 0.0970 | 1.2 | Hexagonal phase, Ga polarity | 5.0 |
| Example 20 | 0 | 0.340 | 0.0920 | 1.1 | Hexagonal phase, Ga polarity | 4.8 |

Note that the entire contents of Description, Claims, Abstract and Drawings of JP2021-063918 filed in the Japan Patent Office on April 5, 2021 are incorporated herein by reference as disclosure of Description of the present invention.

### REFERENCE SYMBOLS

- 1: multilayer film structure
- 2: SiC substrate
- 3: nitride-based film
- 4: amorphous layer
- 5: light-emitting diode
- 6: drift layer
- 7: electrode
- 8: light-emitting layer
- 9: transistor
- 10: electron transport layer
- 11: electron generation layer
- 12: barrier layer

## Claims

1. A multilayer film structure comprising a SiC substrate and a film disposed on the SiC substrate and containing a nitride-based material at least containing Ga, wherein the multilayer film structure has an off-angle of 0.03° or more and 8° or less with respect to a Silicon face of a (0001) plane of a SiC single crystal forming the SiC substrate and the film containing the nitride-based material has a C content of 2 × 10¹⁹ atoms/cm³ or less and a Cl content of 2 × 10¹⁸ atoms/cm³ or less.

2. The multilayer film structure according to claim 1, wherein a (0002) plane in a surface has a rocking-curve full width at half maximum of 5.30° or less.

3. The multilayer film structure according to claim 1, wherein the nitride-based material is gallium nitride.

4. The multilayer film structure according to any one of claims 1 to 3, wherein the multilayer film structure has a surface having an arithmetic average roughness (Ra) of 10.0 nm or less.

5. The method according to any one of claims 1 to 4, wherein the film containing the nitride-based material has a film thickness of 20 nm or more.

6. The multilayer film structure according to any one of claims 1 to 5, wherein the multilayer film structure has a surface formed of a hexagonal gallium nitride layer and the gallium nitride layer has a surface having gallium (Ga) polarity.

7. The multilayer film structure according to any one of claims 1 to 6, wherein an amorphous is present on the SiC substrate and the amorphous layer has a thickness of 0 nm or more and less than 1.0 nm.

8. The multilayer film structure according to claim 7, wherein the amorphous layer has a thickness of more than 0 nm and less than 1.0 nm.

9. The multilayer film structure according to any one of claims 1 to 8, wherein the film containing the nitride-based material is a gallium nitride-based sputtered film.

10. A semiconductor device comprising the multilayer film structure according to any one of claims 1 to 9.

11. An electronic device comprising the semiconductor device according to claim 10.

12. A method for producing the multilayer film structure according to any one of claims 1 to 9, the method comprising a step of preparing a SiC substrate, a step of immersing the SiC substrate in a cleaning solution and a step of forming, on the immersed SiC substrate, a film containing a nitride-based material by a sputtering process, wherein, during formation of the film containing the nitride-based material, a sputtering energy (Es) represented by Formula: Es = [supplied power (unit: W/cm²)]/[introduced gas pressure (unit: Pa)]² is set to 0.1 W/cm²Pa² or more and 150 W/cm²Pa² or less.

13. The production method according to claim 12, wherein the sputtering process is performed after an ultimate vacuum of less than 5.0 × 10⁻⁴ Pa is reached.

14. The production method according to claim 12 or 13, wherein, during formation of the film containing the nitride-based material, an ultimate vacuum within a film-forming apparatus immediately before film formation is set to 1 × 10⁻⁴ Pa or less.

15. The production method according to any one of claims 12 to 14, wherein the sputtering process is performed using a target having a carbon content of 1 mass% or less and a chlorine content of 100 ppm or less.
